# EUROPEAN PATENT APPLICATION

(11) **EP 2 273 631 A2**
(43) Date of publication of application: **12.01.2011**
(21) Application number: 10163569.6
(22) Date of filing: 21.05.2010
(51) Int. Cl.: H01S 5/183, H01S 5/10

(54) **Laser diode and printhead including the laser diode**

(30) Priority: 11.06.2009 KR 20090051949
(71) Applicant: SAMSUNG ELECTRONICS CO., LTD., Suwon-si, Gyeonggi-do (KR); Postech Academy-Industry- Foundation, Gyeongsangbuk-do (KR)
(72) Inventor: Choi, An-sik, Gyeonggi-do (KR); Kwon, O-dae, Seoul (KR); Yoo, Jae-hwan, Gyeonggi-do (KR); Kim, Young-chun, Seoul (KR); Chae, Kwang-hyun, Busan Metropolitan city (KR); Kim, Chang-hoon, Busan Metropolitan city (KR); Shin, Mi-hyang, Busan Metropolitan city (KR)
(74) Representative: Walaski, Jan Filip

(57) **Abstract**

Provided are a semiconductor laser diode, and a printhead and an image forming apparatus including the semiconductor laser diode. The semiconductor laser diode includes a concave-convex pattern (51), and emits light having a Gaussian light intensity distribution. High quality images are provided by applying the semiconductor laser diode to a printhead and an image forming apparatus.
The laser diode may be a VCSEL with the mesa having the concave-convex pattern (51) at the circumference.
Light oscillates along the circumference in form of a photonic quantum ring resonator thereby realizing a three-dimensional Rayleigh resonator.

## Description

The present invention relates to a semiconductor laser diode, and a printhead and an image forming apparatus including the semiconductor laser diode.

In general, in an electrophotographic image forming apparatus, a laser beam is scanned onto a photosensitive medium to expose the photosensitive medium to light to form an electrostatic latent image, and toner is supplied between the photosensitive medium and a developing roller that is arranged a distance from the photosensitive medium so that the toner is selectively attached onto an image forming unit by electric properties of toner.

The electrophotographic image forming apparatus includes a laser scanning unit scanning a laser beam onto the photosensitive medium. The laser scanning unit requires precise optical arrangement and is expensive.

One alternative to the laser scanning unit is a printhead. A light emitting diode (LED) used as a light source of the printhead relies only on random self-emission, and thus does not have high output characteristics, high frequency characteristics, directivity, coherence, or the like at a threshold voltage or greater, which are problems of the stimulated emission of a laser. Although the LED does not have laser speckles, there is the problem of low light output efficiency. Also, if a large amount of current is applied to the LED, the LED may overheat.

Accordingly, it is an aspect of the embodiments to provide a semiconductor laser diode that has a Gaussian optical distribution and is resistant to high temperature.

It is another aspect of the embodiments to provide a printhead and an image forming apparatus including the semiconductor laser diode having a Gaussian optical distribution and resistance to high temperature.

Additional aspects and/or advantages will be set forth in part in the description which follows and, in part, will be apparent from the description, or may be learned by practice.

The foregoing and/or other aspects of the embodiments are achieved by providing a semiconductor laser diode including: a resonator including an n-type distributed Bragg reflector (DBR), a p-type DBR, and an active layer disposed between the n-type DBR and the p-type DBR; and a concave-convex pattern included on a surface of the resonator.

The concave-convex pattern may include a plurality of round convex portions and a plurality of round concave portions. Sizes of neighbouring convex portions of the plurality of the round convex portions of the concave-convex pattern may be different. The convex portions of the concave-convex pattern may have the same size.

A line formed by linking outermost points of the concave-convex pattern may approximately form a circle. A line formed by linking outermost points of the concave-convex pattern may approximately form a square. A hole may be formed in a centre portion of the semiconductor laser diode.

The semiconductor laser diode may further include a coating layer that is included on a circumference of the concave-convex pattern and allows light that is oscillated in the active layer to be confined by a photonic quantum ring (PQR) Rayleigh confinement condition. The resonator may be a three-dimensional Rayleigh resonator. The semiconductor laser diode may emit light having a Gaussian distribution.

The foregoing and/or other aspects of the embodiments may also be achieved by providing a printhead that selectively irradiates light onto a photosensitive medium for each pixel, including: a light source unit in which a semiconductor laser diode is arranged to correspond to each pixel; and a light focusing unit focusing light that is emitted from the light source unit onto a photosensitive medium, wherein the semiconductor laser diode includes a resonator including an n-type distributed Bragg reflector (DBR), a p-type DBR, and an active layer disposed between the n-type DBR and the p-type DBR, and a concave-convex pattern included on a circumference of the resonator.

The foregoing and/or other aspects of the embodiments may be achieved by providing an image forming apparatus including: a photosensitive medium on which a latent image is formed; a printhead, including: a light source unit including a plurality of semiconductor laser diodes respectively corresponding to a plurality of pixels of the image, and a light focusing unit focusing light that is emitted from the light source unit onto the photosensitive medium; a developing unit supplying a developing agent onto the photosensitive medium to form an image corresponding to the latent image; a transfer unit transferring the image formed on the photosensitive medium to a printing medium; and a fixing unit fixing the image transferred to the printing medium, wherein each of the semiconductor laser diodes include a resonator including an n-type distributed Bragg reflector (DBR), a p-type DBR, and an active layer disposed between the n-type DBR and the p-type DBR, and a concave-convex pattern included on a circumference of the resonator.

The above and other features and advantages of the embodiments will become more apparent by describing in detail exemplary embodiments thereof with reference to the attached drawings in which:
FIG. 1 is a perspective view of a semiconductor laser diode according to an embodiment;
FIG. 2A is a cross-sectional view illustrating the semiconductor laser diode taken along line II-II of FIG. 1;
FIG. 2B is a magnified view of a portion A of FIG. 2A;
FIG. 3 is a variation of the semiconductor laser diode of FIG. 1;
FIG. 4A is a perspective view illustrating a semiconductor laser diode according to yet another embodiment;
FIG. 4B is a variation of the semiconductor laser diode of FIG. 4A;
FIG. 5A illustrates dimensions of a semiconductor laser diode according to an embodiment;
FIG. 5B is a charge coupled device (CCD) image of light emission when a current of 100 µA is applied to a 3 x 3 array of the semiconductor laser diode of FIG. 5A;
FIG. 5C is a CCD image of light emission when a current of 150 µA is applied to a 3 x 3 array of the semiconductor laser diode of FIG. 5A;
FIG. 5D is a CCD image of light emission when a current of 200 µA is applied to a 3 x 3 array of the semiconductor laser diode of FIG. 5A;
FIG. 5E is a CCD image of light emission when a current of 250 µA is applied to a 3 x 3 array of the semiconductor laser diode of FIG. 5A;
FIG. 6A illustrates dimensions of a semiconductor laser diode according to another embodiment;
FIG. 6B is a CCD image of light emission when a current of 100 µA is applied to a 3 x 3 array of the semiconductor laser diode of FIG. 6A;
FIG. 6C is a CCD image of light emission when a current of 150 µA is applied to a 3 x 3 array of the semiconductor laser diode of FIG. 6A;
FIG. 6D is a CCD image of light emission when a current of 200 µA is applied to a 3 x 3 array of the semiconductor laser diode of FIG. 6A;
FIG. 6E is a CCD image of light emission when a current of 250 µA is applied to a 3 x 3 array of the semiconductor laser diode of FIG. 6A;
FIGS. 7A1 through 7D2 illustrate light intensity distributions of the semiconductor laser diode of FIG. 5A measured by a fiber tip at heights of about 0, 30, 60, and 90 µm from the semiconductor laser diode, respectively, when a current of 20 µA is applied;
FIGS. 8A1 through 8D2 illustrate light intensity distributions of the semiconductor laser diode of FIG. 6A measured by a fiber tip at heights of 0, 30, 60, and 90 µm, respectively, when a current of 25 µA is applied;
FIG. 9A is a CCD image of light emitted by a semiconductor laser diode having no concave-convex pattern as a comparative example of a semiconductor laser diode of the embodiment;
FIG. 9B illustrates beam power according to a beam diameter of the semiconductor laser diode of FIG. 9A;
FIG. 10A is a CCD image of light emitted by the semiconductor laser diode of FIG. 5A;
FIG. 10B illustrates beam power according to a beam diameter of the semiconductor laser diode of FIG. 10A;
FIG. 11 is a schematic view illustrating a printhead according to an embodiment; and
FIG. 12 is a schematic view illustrating an image forming apparatus according to an embodiment.

Reference will now be made in detail to the embodiments, examples of which are illustrated in the accompanying drawings, wherein like reference numerals refer to the like elements throughout.

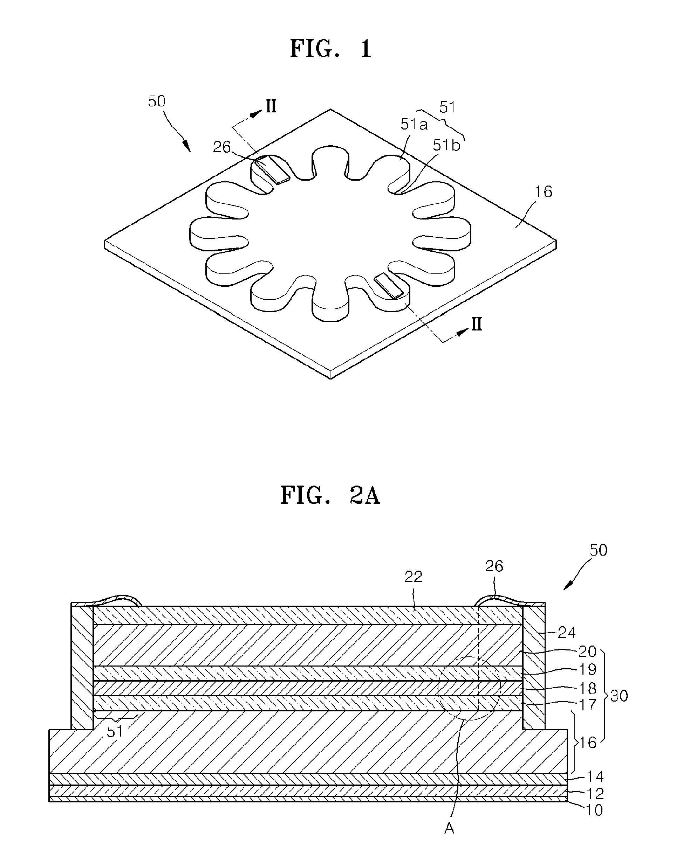

FIG. 1 is a perspective view of a semiconductor laser diode 50 according to an embodiment. Referring to FIG. 1, the semiconductor laser diode 50 includes a concave-convex pattern 51 on a lateral circumference of the semiconductor laser diode 50. The concave-convex pattern 51 includes a plurality of convex portions 51a and a plurality of concave portions 51b that are alternately arranged along the circumference of the semiconductor laser diode 50. The convex portions 51a and the concave portions 51b may have round edges. However, the form of the convex portions 51a and the concave portions 51b is not limited thereto, and may instead have a polygonal shape. Also, in FIG. 1, one semiconductor laser diode is illustrated, but a plurality of semiconductor laser diodes may be integrated in an array on one substrate.

FIG. 2A is a cross-sectional view illustrating the semiconductor laser diode 50 of FIG. 1, taken along line II-II. The semiconductor laser diode 50 includes a resonator 30 and the concave-convex pattern 51 included on a circumference of the resonator 30. The resonator 30 may include an n-type distributed Bragg reflector (DBR) 16, a p-type DBR 20, and an active layer 18 disposed between the n-type DBR 16 and the p-type DBR 20. The semiconductor laser diode 50 may be a photonic quantum ring (PQR) laser diode that oscillates light along the circumference of the active layer 18. Light oscillates at an angle with respect to a vertical axis direction of the laser diode along the circumference of the active layer 18. A PQR laser diode has a structure for which the strict oscillation conditions of a vertical cavity surface emitting laser (VCSEL) are mitigated. Unlike the VCSEL, an oscillation area of the PQR laser diode is limited to a Rayleigh band along the circumference of the active layer, and thus the PQR laser diode shows unique PQR type oscillation (see "Photonic Quantum Ring" by J.C. Ahn, K.S. Kwak, B. H. Park, H.Y. Kang, J. Y. Kim and O'Dae Kwon, Phys. Rev. Lett. Vol. 82, No.3 pp 536-539 (Jan. 1999); "Hole emitter of photonic quantum ring" by O'Dae Kwon, M. J. Kim, S.-J. An, D. K. Kim, S. E. Lee, J. Bae, J. H. Yoon, B. H. Park, J. Y. Kim, and J. Ahn, Appl. Phys. Lett, Vol. 89, 11108 (July. 2006)).

For example, the resonator 30 may be a three-dimensional Rayleigh resonator. Meanwhile, a coating layer 24 may be further included on the circumference of the concave-convex pattern 51. The coating layer 24 may be adjusted such that light oscillated in the active layer 18 satisfies a PQR Rayleigh confinement condition.

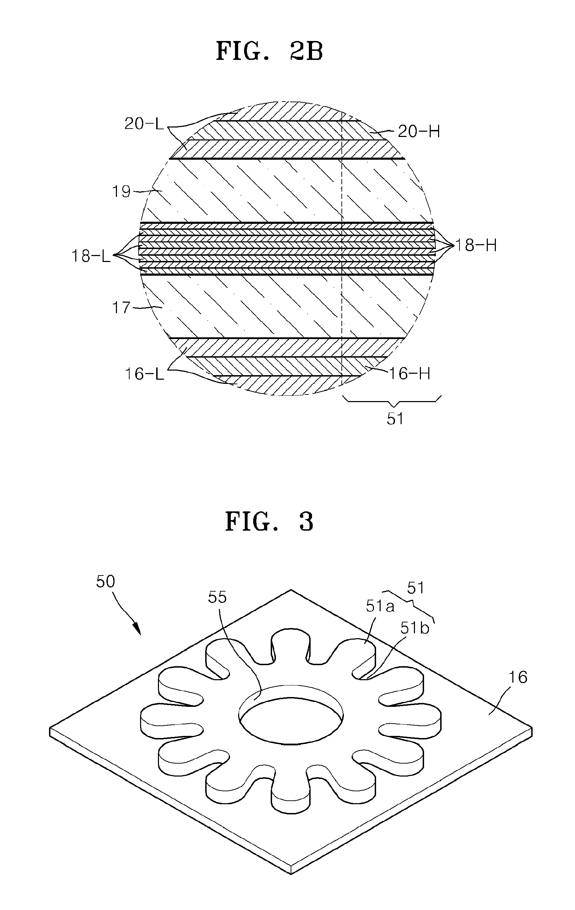

The resonator 30 is disposed on a substrate 12 that may be formed of a material such as gallium arsenide (GaAs), indium phosphide (InP), or the like. The substrate 12 is n+ doped so that a multi-layer is epitaxially grown easily on the substrate 12. A buffer layer 14 may be included between the substrate 12 and the n-type DBR 16, and an n-electrode 10 may be included under the substrate 12. The n-type DBR 16 is formed of alternately stacked layers having two different refractive indices. FIG. 2B is a magnified view of a portion A of FIG. 2A. For example, as shown in FIG. 2B, the n-type DBR 16 may include first layers 16-L formed of AlₓGa₁₋ₓAs and second layers 16-H formed of Al_{y}Ga_{1-y}As that are alternately stacked (x and y are real numbers equal to or greater than 0 and smaller than or equal to 1). As an example, there may be 40 of the second layers 16-H and 41 of the first layers 16-L. The first layers 16-L may have a relatively low refractive index, and the second layers 16-H may have a relatively high refractive index. The first layers 16-L and the second layers 16-H may each have a thickness of λ/4n (n is the refractive index of a respective layer, and λ is the wavelength of a laser light in free space).

The p-type DBR 20 is designed to be thin and to have alternately stacked layers having two different refractive indices, wherein the number of stacked layers is less than that of the n-type DBR 16, thereby reducing reflectivity. For example, the p-type DBR 20 may be formed by alternately stacking third layers 20-L formed of AlₓGa₁₋ₓAs and fourth layers 20-H formed of Al_{y}Ga_{1-y}As. As an example, 30 of each of the layers 20-L and 20-H may be stacked. The third layers 20-L and the fourth layers 20-H may each have a thickness of λ/4n.

A first space layer 17 may be disposed between the n-type DBR 16 and the active layer 18, and a second space layer 19 may be further disposed between the active layer 18 and the p-type DBR 20. The first space layer 17 and the second space layer 19 may be formed of AlGaAs. The active layer 18 may be formed by alternately stacking fifth layers 18-L having a relatively low bandgap energy and sixth layers 18-H having a relatively high bandgap energy. For example, the fifth layers 18-L may be formed of Al_{z}Ga_{1-z}As (0≤ z ≤1), and the sixth layers 18-H may be formed of AlₓGa₁₋ₓAs. The active layer 18 may include eight layers in total. A plurality of quantum wells, for example, four quantum wells, may be formed in the active layer 18. The total thicknesses of the first and second space layers 17 and 19 and the active layer 18 may be determined in consideration of refractive indices thereof. A capping layer 22 may be formed on the p-type DBR 20. For example, the capping layer 22 may be formed of p+ GaAs.

After epitaxially growing the above structure, a side portion of the resonator 30 including the n-type DBR 16, the active layer 18, and the p-type DBR 20 is etched vertically. The side portion of the resonator 30 is etched such that the concave-convex pattern 51 is formed in the side portion. When etching the side portion of the resonator 30, a dry etching method such as a chemically assisted ion beam etching (CAIBE) method may be used. The side portion of the resonator 30 may be etched down to a predetermined depth of the n-type DBR 16.

After the etching, a protection layer (not shown) may be formed in order to protect surfaces of the semiconductor laser diode 50 including the active layer 18. The protection layer may be formed by depositing a dielectric material such as silicon nitride (SiNₓ) by using a plasma enhanced chemical vapor deposition (PECVD) method. The coating layer 24 is formed using a polyimide planarization method to planarize the etched semiconductor laser diode 50. The coating layer 24 may be used as a path to transmit light oscillated along the circumference of the active layer 18.

Meanwhile, the silicon nitride is removed by using a buffered oxide etching (BOE) method so that an upper surface of the semiconductor laser diode 50 is exposed. Then, the n-electrode 10 may be included under the substrate 12 by using an n-metal process, and a p-electrode 26 may be included on the capping layer 22 and the coating layer 24 by using a p-metal process. The p-electrode 26 may be a striped electrode or a multi-segmented electrode.

The semiconductor laser diode 50 according to the embodiment is not limited to the above structure. The structure and materials of the active layer 18, the p-type DBR 20, and the n-type DBR 16 may be modified according to a laser oscillation wavelength. The laser oscillation wavelength may be, for example, 850 nm, 780 nm, or 680 nm.

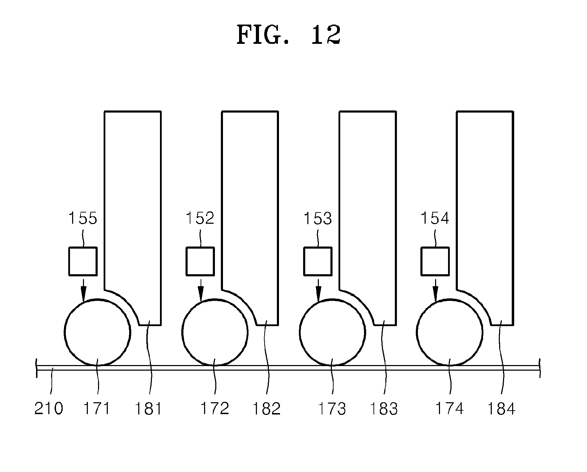

The number of the convex portions 51a of the concave-convex pattern 51 of the semiconductor laser diode 50 according to the current embodiment may be varied. In FIG. 1, 12 of the convex portions 51a are included. The size of a PQR in the active layer 18 may increase according to the number of the convex portions 51a and the concave portions 51b.

FIG. 3 is another example of the semiconductor laser diode 50 of FIG. 1, wherein the semiconductor laser diode 50 further includes a hole 55 formed in a centre portion thereof. The hole 55 may be formed, for example, to a predetermined depth of the n-type DBR 16 (see "Hole emitter of photonic quantum ring", by O'Dae Kwon, M. J. Kim, S.J. An, D. K. Kim, S. E. Lee, J. Bae, J. H. Yoon, B. H. Park, J. Y. Kim, and J. Ahn, Appl. Phys. Lett, Vol. 89, 11108 (July. 2006)). Due to the hole 55, a surface area for PQR oscillation may increase. A line formed by linking outermost points of the convex portions 51a of the semiconductor laser diode 50 illustrated in FIGS. 1 and 3 may approximately be a circle. In addition, sizes of the convex portions 51a may be substantially the same.

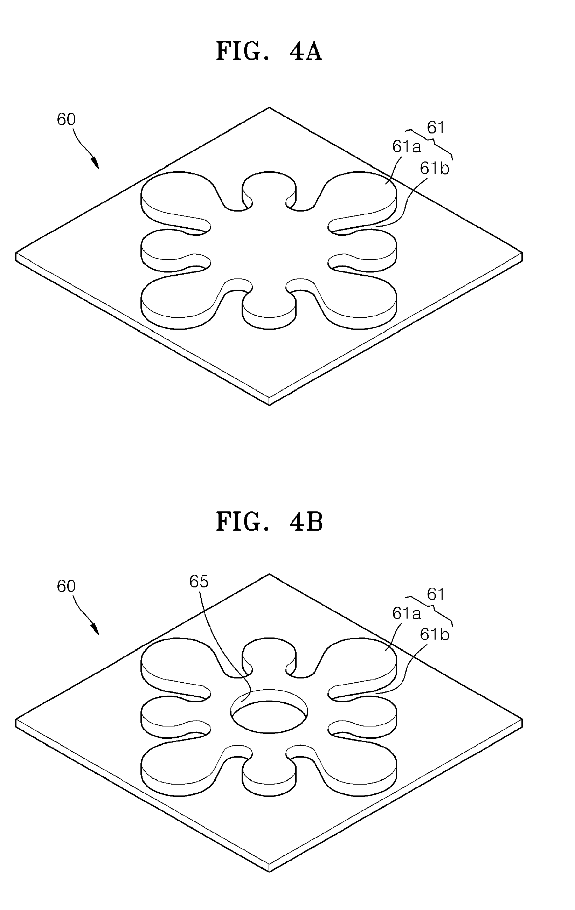

FIG. 4A is a perspective view illustrating a semiconductor laser diode 60 according to another embodiment. The structure of the laser diode 60 is substantially the same as the layer structure of the semiconductor laser diode 50 of FIG. 1, and thus detailed description thereof will not be repeated. The semiconductor laser diode 60 includes a concave-convex pattern 61 including a plurality of convex portions 61a and a plurality of concave portions 61b that are alternately arranged. A line formed by linking outermost points of the convex portions 61a may approximately be a square. Also, as illustrated in FIG. 4A, sizes of neighbouring convex portions of the convex portions 61a may be different. FIG. 4B is another example of the semiconductor laser diode 60 of FIG. 4A, wherein the semiconductor laser diode 60 further includes a hole 65 formed in a centre portion thereof.

In the semiconductor laser diode 60 according to the current embodiment, a p-type DBR 20 above and an n-type DBR 16 below a multi quantum well active layer 18 vertically confine photons. Also, a toroid cavity is formed by confining photons horizontally by total internal reflection at a circumference of the active layer 18. In other words, the toroid cavity is formed by in-plane annular Rayleigh confinement due to a large difference between the refractive indices of the active layer 18 and a coating layer 24, inter-reflection potential at an inner portion of the active layer 18, and the above-described vertical confinement. Carriers on an active surface of the multi quantum well active layer 18 in the middle of a space within the boundary defined as the toroid cavity are transitionally redistributed, for example, into a form similar to concentric circles of quantum wires, due to a photonic quantum corral effect, and are involved in an electron-hole rebonding process to generate photons. Then, the toroid cavity is deformed to resonate in a three-dimensional concave-convex whispering cave mode (WCM), thereby increasing the size of an effective quantum ring and extending a PQR area toward the centre of the active layer. Accordingly, the semiconductor laser diode 60 according to the embodiment allows a luminous flux to have a Gaussian distribution. Also, if a hole is formed in a centre portion of the semiconductor laser diode 60, oscillation occurs in the hole, and thus light having an intensified Gaussian distribution may be obtained.

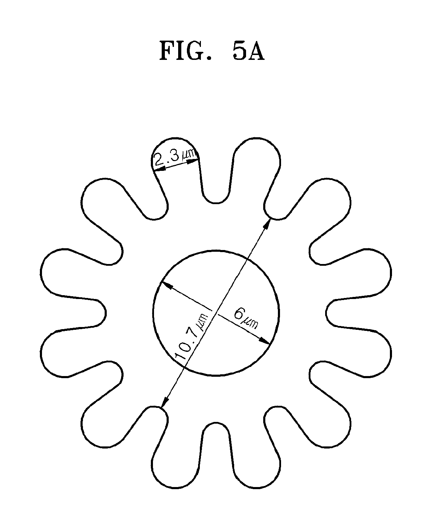

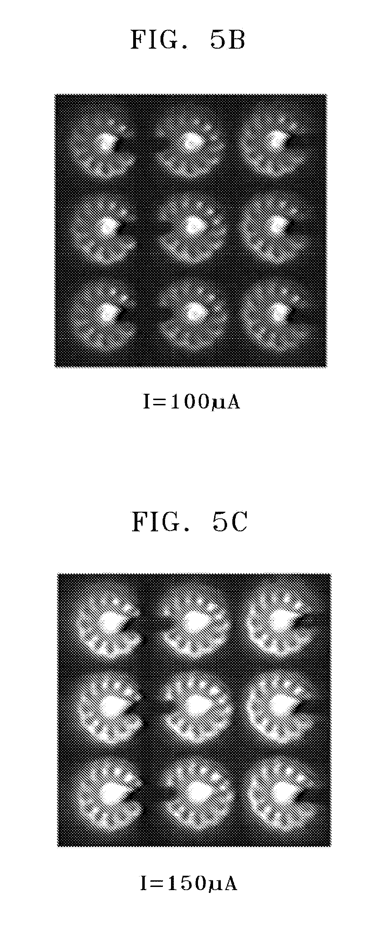

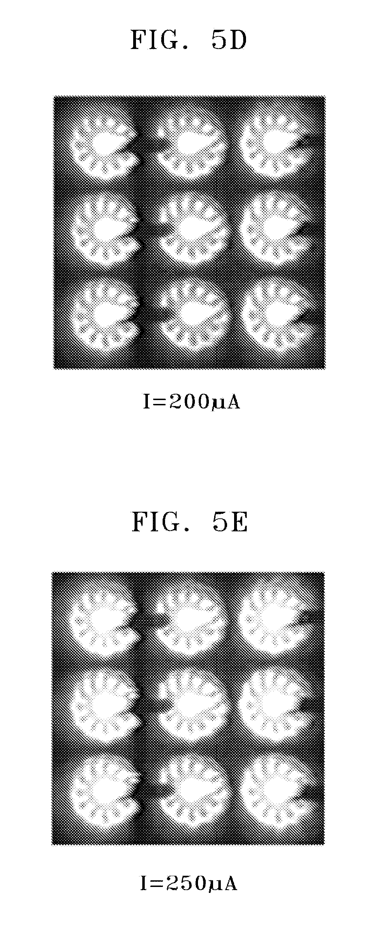

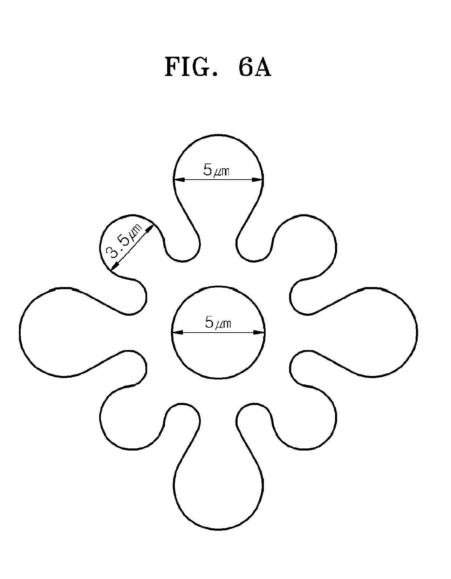

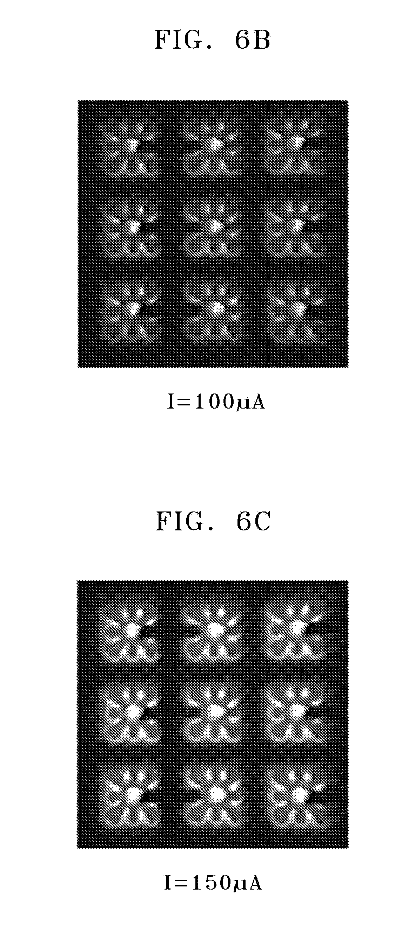

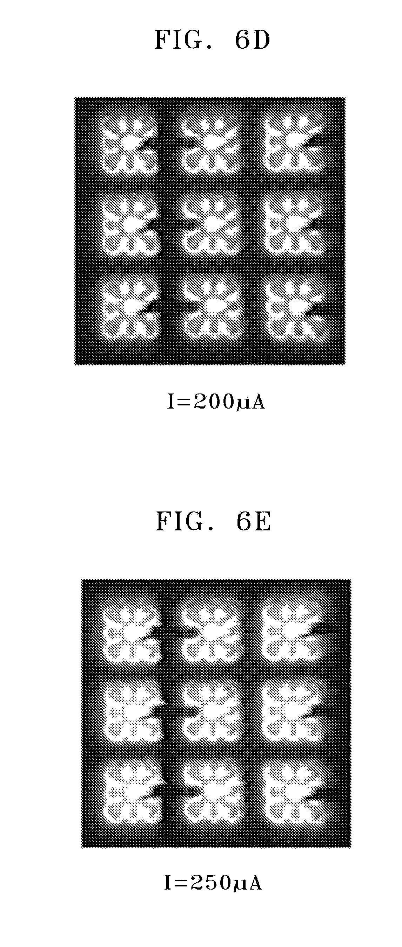

FIG. 5A illustrates an approximately circular semiconductor laser diode having a width of 15 µm, 12 convex portions, and a hole. FIGS. 5B through 5E are charge coupled device (CCD) images of light emission when currents of 100, 150, 200, and 250 µA are applied to a 3 x 3 array of the semiconductor laser diode illustrated in FIG. 5A. FIG. 6A illustrates an approximately square semiconductor laser diode having a width of 15 µm, eight convex portions, and a hole. FIGS. 6B through 6E are charge coupled device (CCD) images of light emission when currents of 100, 150, 200, and 250 µA are applied to a 3 x 3 array of the semiconductor laser diode illustrated in FIG. 6A. Here, only 10% of total light emission is transmitted due to using a natural density filter since an increase of the current causes an amount of light emission that saturates a CCD. When a hole is included in the semiconductor laser diode, hole PQR oscillation occurs in the centre of the semiconductor laser diode.

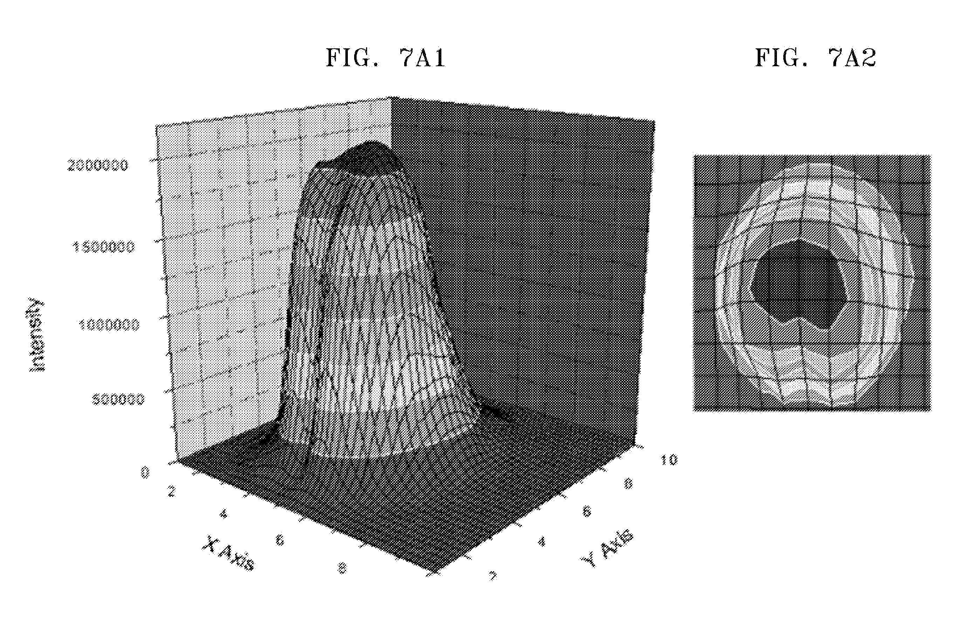

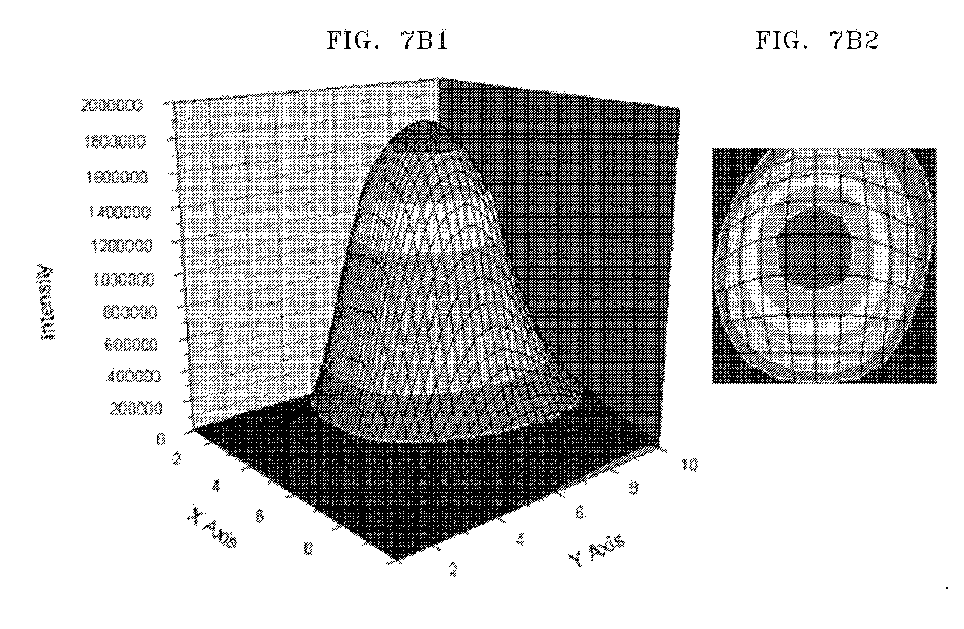

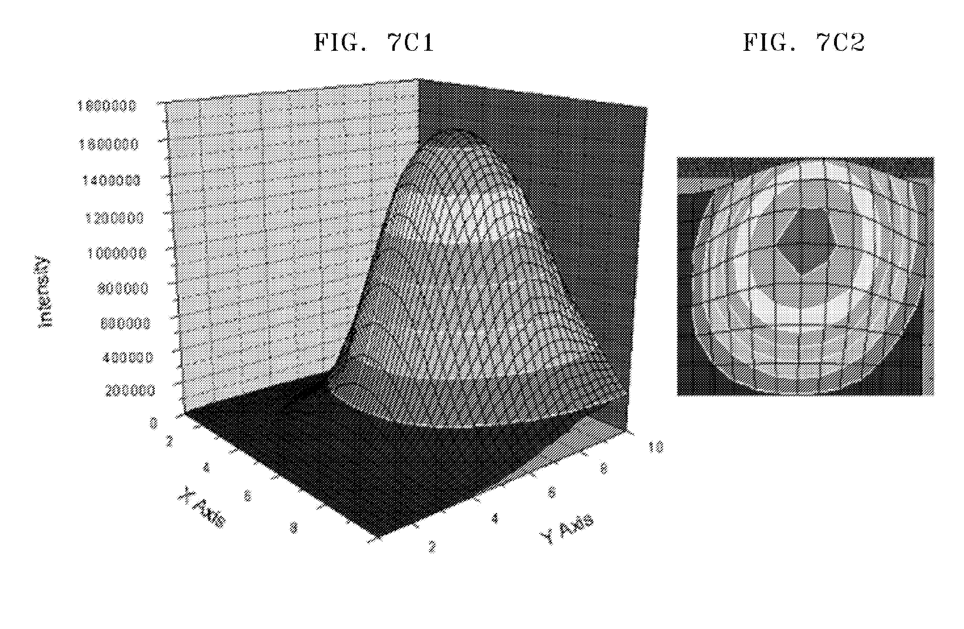

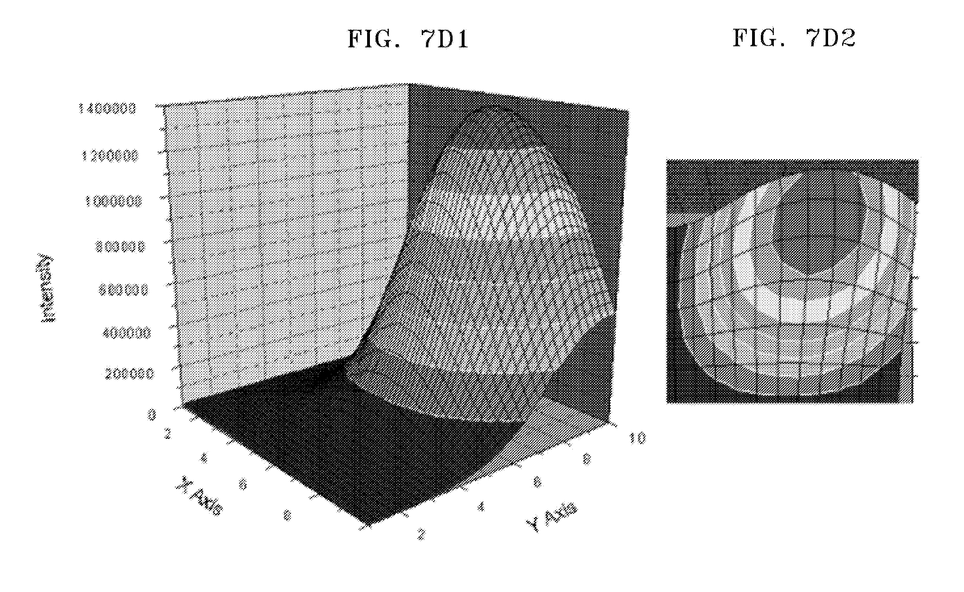

FIGS. 7A1 through 7D2 illustrate light intensity distributions of the semiconductor laser diode of FIG. 5A measured by a fiber tip at heights of 0, 30, 60, and 90 µm from the semiconductor laser diode, respectively when a current of 20 µA is applied. FIGS. 7A1 and 7A2 show the light intensity distribution of the semiconductor laser diode measured at 0 µm when applying a current of 20 µA to the semiconductor laser diode of FIG. 5A. FIG. 7A1 is a perspective view and FIG. 7A2 is a top view. A dented portion in FIG. 7A1 is formed because a small number of photons come about due to a p-electrode of the semiconductor laser diode. As the measurement height is increased to 30, 60, and 90 µm, the width of a beam is increased, the profile of the beam follows a Gaussian distribution, and the peak of light intensity is decreased.

The beam profile is measured as follows. First, a fiber tip is placed near the semiconductor laser diode, and the fiber tip is connected to a single photon counting module (SPCM) and the number of photons entering the fiber tip is converted to an electrical signal to input the number to a computer. In order to obtain a precise photon distribution at all positions on a plane parallel to the semiconductor laser diode, a fiber mount is connected to a step motor to conduct x-y axis scanning over an area of 60 x 60 µm². The light intensity is measured at an interval of 1 µm along the x-axis, and after one x-y axis scanning, the height of the fiber tip is increased by 30 µm. A fiber tip that has a core radius of 1 µm or less formed by etching an end of a single mode fiber (core/cladding: 9/125µm) into a cone shape by using hydrogen fluoride (HF) may be used as the fiber tip. Thus, measurement sections are not repeated when measuring 1 µm intervals along the x-axis.

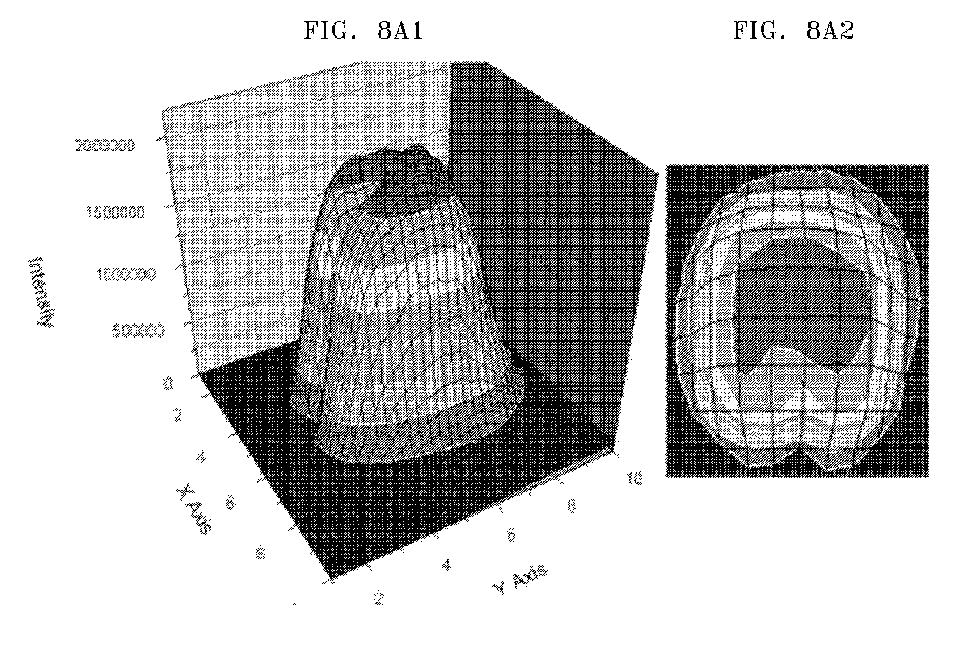

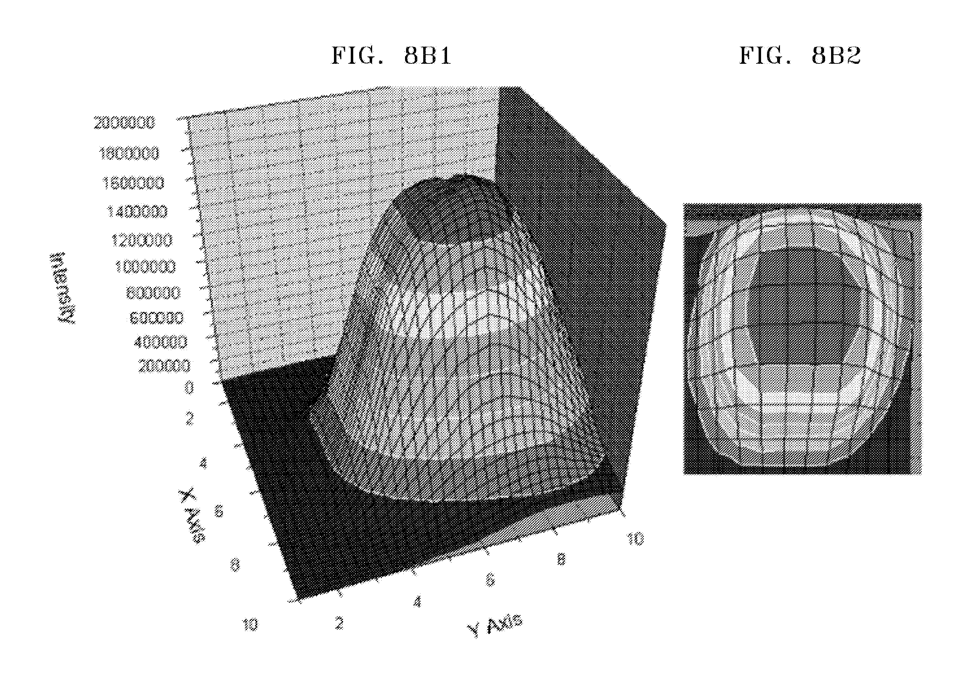

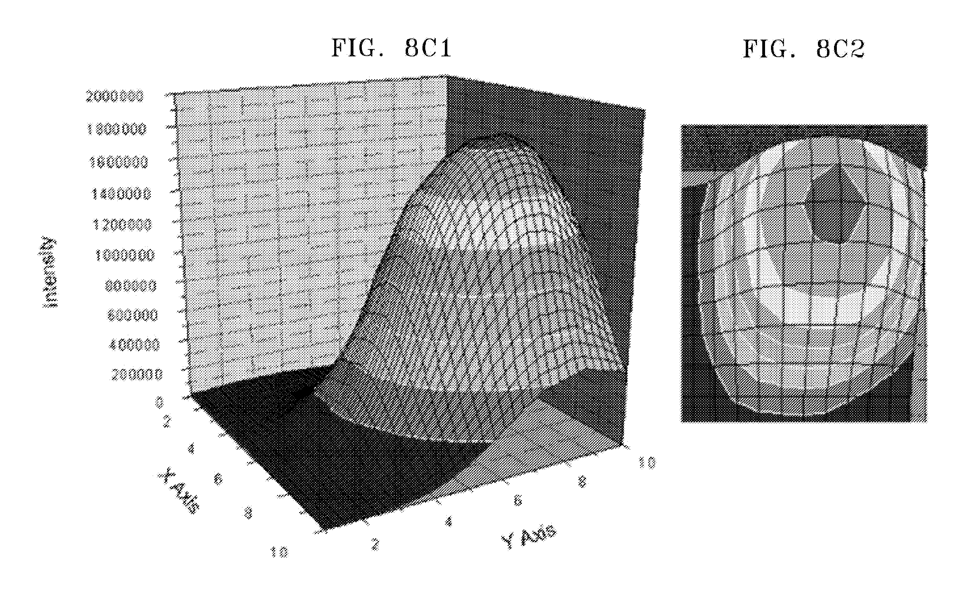

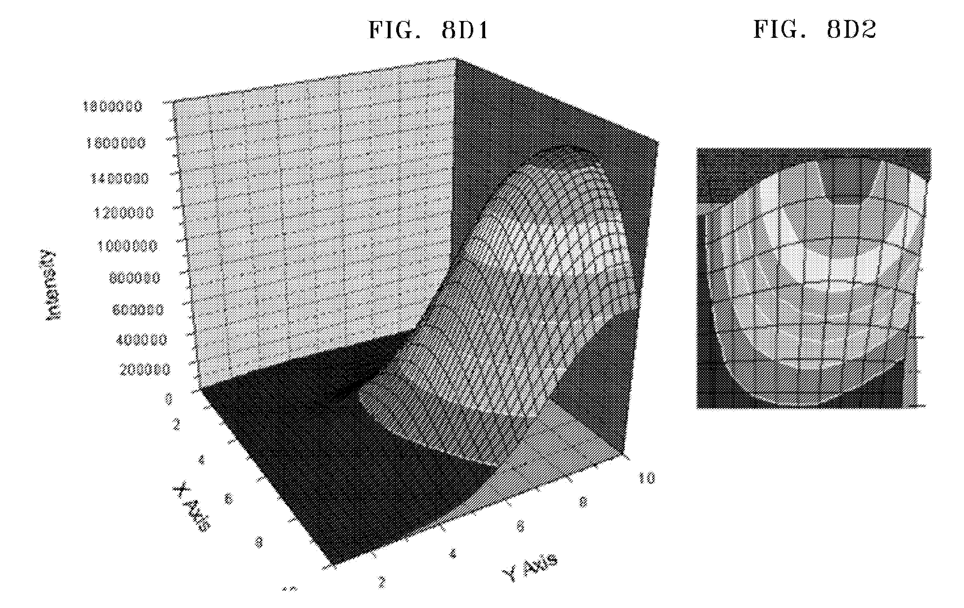

FIGS. 8A1 through 8D2 illustrate light intensity distributions of the semiconductor laser diode of FIG. 6A when a current of 25 µA is applied, wherein the light intensity distributions are measured by a fiber tip at heights of 0, 30, 60, and 90 µm, respectively. Referring to FIGS. 8A1 and 8A2, at a height of 0 µm, a decreasing portion in the light intensity due to an electrode is observed. Up to the measurement height of 30 µm, the shape of a beam is approximately a square, but at 60 µm and 90 µm, a Gaussian distribution is shown. Accordingly, in this case, a Gaussian distribution is shown in a far-field region.

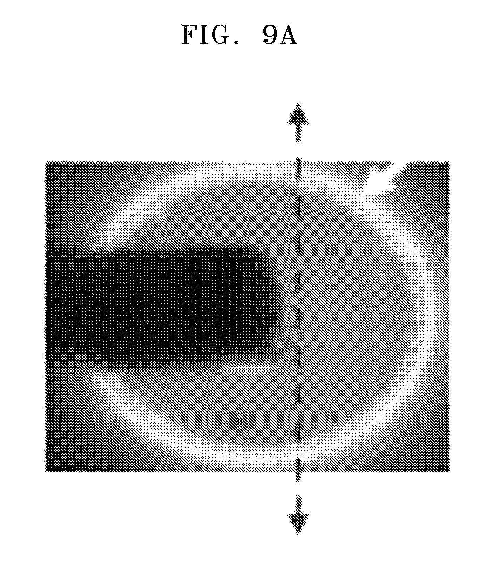

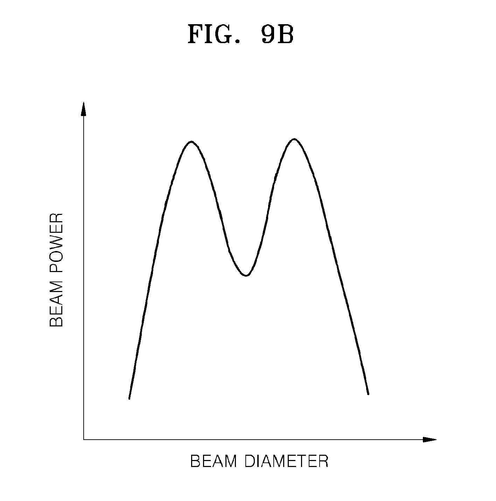

FIG. 9A is a photographic image of light emission of a semiconductor laser diode having no concave-convex pattern as a comparative example of the semiconductor laser diode of the embodiment. FIG. 9B is a graph illustrating beam power according to a beam diameter of the semiconductor laser diode of FIG. 9A, where a beam profile shows no Gaussian distribution.

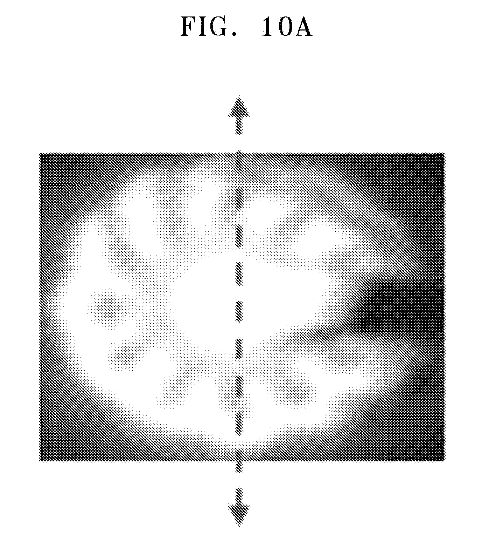

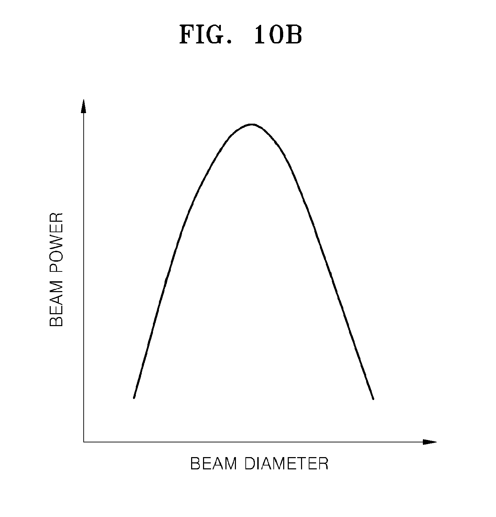

FIG. 10A is a photographic image of light emission of the semiconductor laser diode of FIG. 5A. FIG. 10B is a graph illustrating beam power according to a beam diameter of the semiconductor laser diode of FIG. 10A.

The semiconductor laser diode according to the embodiment is a PQR laser having a three-dimensional resonance structure with a relatively large modulation range of high frequency compared to a light emitting diode (LED). The PQR laser diode has no directivity or speckles, has a low threshold current, and has high temperature stability. Also, the semiconductor laser diode according to the embodiment may have a modulation frequency of 1 - 1000 MHz.

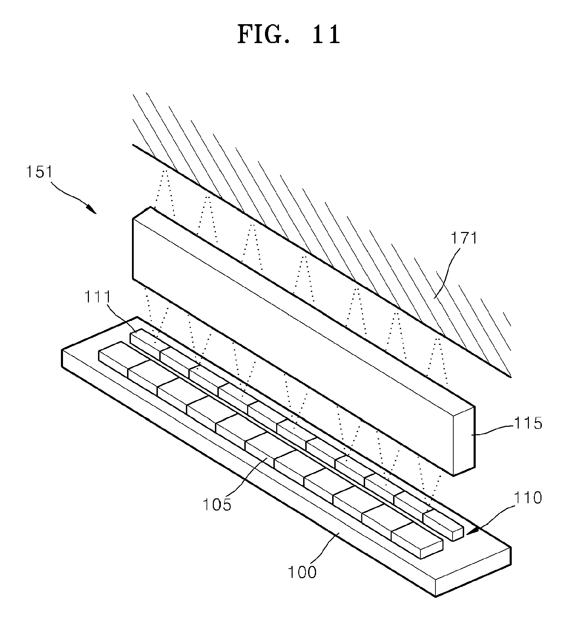

FIG. 11 is a schematic view illustrating a printhead 151 according to an embodiment. A photosensitive medium 171 is arranged near the printhead 151. The printhead 151 includes a light source unit 110 including a plurality of semiconductor laser diodes 111 arranged in an array, and a light focusing unit 115 that focuses light that is emitted from the light source unit 110 to the photosensitive medium 171. The semiconductor laser diodes 111 may be arranged on a printed circuit board (PCB) substrate 100 so as to correspond to pixels. The semiconductor laser diodes 111 include a concave-convex pattern formed on a circumference of a resonator. The semiconductor laser diodes 111 may be a plurality of any of the semiconductor laser diodes described above with reference to FIGS. 1, 3, 4A, and 4B. A drive integrated circuit (IC) 105 driving the semiconductor laser diodes 111 may be formed on the PCB substrate 100.

The light focusing unit 115 may include a micro lens array or a Selfoc lens array. The semiconductor laser diode 111 is turned on or off according to an image signal from a main board in a printer. A beam emitted from the semiconductor laser diode 111 to the light focusing unit forms a beam spot having a Gaussian shape corresponding to 600 dpi or 1200 dpi resolution, for example. Thus, light emitted from the semiconductor laser diode 111 forms an image onto the photosensitive medium 171 via the light focusing unit 115, thereby forming a latent image on the photosensitive medium 171.

When an LED is used as a light source of the printhead, the light does not have directivity and thus is spread in all directions, and thus it is difficult to focus the light by using a lens. However, when using a semiconductor laser diode according to the embodiment, the light emission angle is narrow and light has a vertical directivity, and thus the light can be easily focused. Also, as the semiconductor laser diode has a Gaussian light intensity distribution as illustrated in FIGS. 10A and 10B, it may be used as a light source of a printhead.

FIG. 12 is a schematic view illustrating an image forming apparatus including a plurality of printheads 155, 152, 153, and 154 according to an embodiment. The printheads 155, 152, 153, and 154 emit light that corresponds to different color toners such as magenta, cyan, yellow, and black and form images corresponding to the colors on a photosensitive medium according to image signals. The printheads 155, 152, 153, and 154 may have substantially the same structure as the printhead 151 described with reference to FIG. 11, and here detailed description thereof will be omitted.

The image forming apparatus according to the embodiment includes first through fourth photosensitive media 171, 172, 173, and 174, the first through fourth printheads 155, 152, 153, and 154 scanning beams onto the first through fourth photosensitive media 171, 172, 173, and 174, a developing unit developing an electrostatic latent image formed on each of the first through fourth photosensitive media 171, 172, 173, and 174, and a transfer unit 210 to which the developed image is transferred. The first through fourth printheads 155, 152, 153, and 154 turn on and off to emit and scan beams according to an image signal onto the first through fourth photosensitive media 171, 172, 173, and 174, thereby forming an electrostatic latent image. The developing unit includes first through fourth developing units 181, 182, 183, and 184 that respectively correspond to the first through fourth photosensitive media 171, 172, 173, and 174.

A developing agent is supplied to each of the photosensitive media 171, 172, 173, and 174 from the first through fourth developing units 181, 182, 183, and 184 to form electrostatic latent images, respectively. The developed images corresponding to each of the photosensitive media 171, 172, 173, and 174 are sequentially transferred to the transfer unit 210, thereby forming color images. A first line transferred from the first photosensitive medium 171 to the transfer unit 210, a second line transferred from the second photosensitive medium 172, a third line transferred from the third photosensitive medium 173, and a fourth line transferred from the fourth photosensitive medium 174 are sequentially overlapped to form a color image, and then the color images are fixed onto a piece of paper. The printheads according to the embodiment may also be applied to image forming apparatuses having different structures than the image forming apparatus illustrated in FIG. 12.

The semiconductor laser diode according to the embodiment may be used as a light source of an electrophotographic image forming apparatus that forms an image onto a printing medium, such as a photocopier, a printer, a facsimile, etc. Moreover, the semiconductor laser diode may be applied to a laser display device that scans a laser beam onto a screen to display an image. Also, the semiconductor laser diode may be used as a light source of a display device.

Although a few embodiments have been shown and described, it would be appreciated by those skilled in the art that changes may be made in these embodiments without departing from the principles of the invention, the scope of which is defined in the claims.

## Claims

1. A semiconductor laser diode comprising:
a resonator including an n-type distributed Bragg reflector DBR, a p-type DBR, and an active layer disposed between the n-type DBR and the p-type DBR; and
a concave-convex pattern on a surface of the resonator.

2. The semiconductor laser diode of claim 1, wherein the concave-convex pattern comprises a plurality of round convex portions and a plurality of round concave portions respectively between the convex portions.

3. The semiconductor laser diode of claim 1 or 2, wherein sizes of neighbouring concave and convex portions are different.

4. The semiconductor laser diode of any one of claims 1 to 3, wherein a line formed by linking outermost points of the concave-convex pattern approximately forms a circle.

5. The semiconductor laser diode of any one of claims 1 to 4, wherein a hole is formed in a centre portion of the semiconductor laser diode.

6. The semiconductor laser diode of any one of claims 1 to 5, further comprising a coating layer that is included on a circumference of the concave-convex pattern and allows light that is oscillated in the active layer to be confined by a photonic quantum ring PQR Rayleigh confinement condition.

7. The semiconductor laser diode of any one of claims 1 to 6, wherein the resonator is a three-dimensional Rayleigh resonator.

8. A printhead for selectively irradiating light onto a photosensitive medium for each of a plurality of pixels, comprising:
a light source unit comprising a plurality of semiconductor laser diodes respectively corresponding to each of the pixels; and
a light focusing unit focusing light that is emitted from the light source unit onto the photosensitive medium, wherein the semiconductor laser diodes each comprise a semiconductor laser diode according to any one of the preceding claims.

9. An image forming apparatus comprising:
a photosensitive medium on which a latent image is formed; a printhead according to claim 8;
a developing unit for supplying a developing agent onto the photosensitive medium to form an image corresponding to the latent image;
a transfer unit for transferring the image formed on the photosensitive medium to a printing medium; and
a fixing unit for fixing the image transferred to the printing medium.
